# FASCICULE DE BREVET EUROPEEN

(11) **EP 0 421 179 B1**
(45) Date de publication et mention de la délivrance du brevet: **01.02.1995**
(21) Numéro de dépôt: 90117835.0
(22) Date de dépôt: 17.09.1990
(51) Int. Cl.: H05K 3/12, H05K 1/09, H01L 21/48

(54) **Procédé de réalisation de pistes conductrices pour circuits hybrides, notamment pour circuits hybrides de puissance**
Herstellungsverfahren von Leiterbahnen für Hybridschaltungen, insbesondere für Leistungs-Hybridschaltungen
Process for making conductor tracks for hybrid circuits, particularly for power hybrid circuits

(30) Priorité: 19.09.1989 FR 8912267
(43) Date de publication de la demande: 10.04.1991
(73) Titulaire: GEC ALSTHOM SA, 75116 Paris (FR)
(72) Inventeur: Chave, Jacques, F-69003 Lyon (FR)
(74) Mandataire: Weinmiller, Jürgen

(56) Documents cités:
- GB-A- 2 123 615
- US-A- 4 847 003
- PROC. OF THE 21TH ELECTRONIC COMPONENTS CONFERENCE, Washington, Mai 10-12 1971,IEEE, New York US, pages 480-486, WIRTZ: "Adhesive strength of thick film Pd-Ag conductors"

## Description

La présente invention concerne un procédé de réalisation de pistes conductrices pour circuits hybrides, notamment pour circuits hybrides de puissance.

On rappelle qu'un circuit hybride est un assemblage de composants électroniques sur un support isolant appelé substrat, sur lesquel est sérigrahié un ensemble de pistes conductrices, résistances, et plots servant à la fixation et/ou à l'interconnexion des composants électroniques de ce circuit ainsi que de ses broches de connexion avec des éléments extérieurs .

Un problème se pose dans le cas de circuits hybrides de puissance, qui est dû au passage de forts courants dans des pistes conductrices de très faible épaisseur (de l'ordre de 15 microns) pouvant entraîner une détérioration de celles-ci.

Le matériau généralement choisi pour la réalisation de ces pistes est un composé argent-palladium, comportant généralement trois quantités d'argent pour une de palladium, l'argent étant utilisé pour ses qualités conductrices et le palladium évitant sa destruction par oxydation à l'air libre et son absorption par les soudures effectuées pour fixer les composants et les broches de connexion de ce circuit aux plots de fixation et d'interconnexion.

La présente invention a pour objet un procédé de réalisation de pistes de circuits hybrides conférant à celles-ci des qualités optimisées pour un fonctionnement du circuit hybride en puissance, notamment une résistivité moindre.

Suivant l'invention, ce procédé de réalisation de pistes conductrices pour circuits hybrides, notamment pour circuits hybrides de puissance, par dépôt sérigraphique d'une matière conductrice sur le substrat desdits circuits hybrides, est essentiellement caractérisé en ce qu'il consiste à réaliser dans une première étape un dépôt sérigraphique d'argent, au moyen d'un masque dont le motif détermine les emplacements desdites pistes, et dans une deuxième étape, par dessus le dépôt sérigraphique réalisé dans la première étape, et au moyen du même masque, un dépôt sérigraphique d'un composé argent-palladium.

Les objets et caractéristiques de la présente invention apparaîtront plus clairement à la lecture de la description suivante d'un exemple de réalisation.

Suivant l'invention, les pistes conductrices sont réalisées en deux étapes:
- dans une première étape, une couche d'encre conductrice en argent est déposée par sérigraphie, sur le substrat du circuit hybride, au moyen d'un masque dont le motif détermine les emplacements desdites pistes;
- dans une deuxième étape, une deuxième couche d'encre conductrice formée d'un composé argent-palladium est déposée par sérigraphie, sur la couche d'argent réalisée dans la première étape et au moyen du même masque.

Le composé argent-palladium utilisé dans cette deuxième étape est avantageusement rechargé en argent par rapport au composé utilisé dans l'art antérieur ; il comporte avantageusement six quantités d'argent pour une quantité de palladium.

Les deux couches d'encre conductrices ainsi réalisées peuvent ensuite être co-cuites de façon classique, dans un four à passage.

Chaque couche a par ailleurs avantageusement une épaisseur de l'ordre de 15 microns, soit une épaisseur globale de 30 microns après cuisson.

Les pistes ainsi obtenues par ce procédé présentent une résistivité moindre, d'où un fonctionnement du circuit hybride optimisé en puissance. Une meilleure résistance à l'arrachement, c'est-à-dire une meilleure adhérence des pistes au substrat du circuit hybride est par ailleurs observée.

## Revendications

1. Procédé de réalisation de pistes conductrices pour circuits hybrides, notamment pour circuits hybrides de puissance, par dépôt sérigraphique d'une matière conductrice sur le substrat desdits circuits hybrides, caractérisé en ce qu'il consiste à réaliser dans une première étape un dépôt sérigraphique d'argent, au moyen d'un masque dont le motif détermine les emplacements desdites pistes, et dans une deuxième étape, par dessus le dépôt sérigraphique réalisé dans la première étape, et au moyen du même masque, un dépôt sérigraphique d'un composé argent-palladium.

2. Procédé selon la revendication 1, caractérisé en ce que ledit composé argent-palladium comporte six quantités d'argent pour une quantité de palladium.

## Patentansprüche

1. Verfahren zur Herstellung von Leiterbahnen für Hybridschaltungen, insbesondere für hybride Leistungsschaltungen, durch serigraphisches Aufbringen eines leitenden Materials auf das Substrat der Hybridschaltungen, dadurch gekennzeichnet, daß in einem ersten Verfahrensschritt mit Hilfe einer Maske, deren Motiv die Stellen für die Leiterbahn bestimmt, Silber serigraphisch aufgebracht wird und in einem zweiten Verfahrensschritt oberhalb der in dem ersten Verfahrensschritt serigraphisch aufgebrachten Schicht mit Hilfe der gleichen Maske eine Silber-Palladium-Mischung aufgebracht wird.

2. Verfahren nach Anspruch 1, dadurch gekennzeichnet, daß die Silber-Palladium-Mischung sechs Teile Silber für ein Teil Palladium aufweist.

## Claims

1. Method of making conductive tracks for hybrid circuits, especially power hybrid circuits, by silkscreened deposition of a conductive material onto the substrate of said hybrid circuits, characterised in that it consists in a first stage entailing silkscreened deposition of silver using a mask whose pattern determines the locations of said tracks and a second stage entailing silkscreened deposition of silver-palladium over the silkscreened deposit obtained in the first stage using the same mask.

2. Method according to claim 1 characterised in that said silver-palladium contains six parts of silver to one part of palladium.
